# EUROPEAN PATENT SPECIFICATION

(11) **EP 0 484 294 B1**
(45) Date of publication and mention of the grant of the patent: **27.10.1993**
(21) Application number: 91830463.5
(22) Date of filing: 29.10.1991
(51) Int. Cl.: B65D 43/12, H05K 5/00, H01L 23/04, H01L 23/10

(54) **A container for electronic equipment**
Behälter für elektronische Teile
Boîtier pour équipement électronique

(30) Priority: 31.10.1990 IT 5335190 U
(43) Date of publication of application: 06.05.1992
(73) Proprietor: MARELLI AUTRONICA S.p.A., 20145 Milano (IT)
(72) Inventor: Vettoretto, Ruffino, I-10139 Torino (IT)
(74) Representative: Quinterno, Giuseppe

(56) References cited:
- DE-U- 7 039 265
- MOTOROLA TECHNICAL DEVELOPMENTS vol. 11, October 1990, SCHAUMBURG, ILLINOIS, US page 155; TAN KIAN TECK ET AL.: 'Locking mechanism for two piece housing'

## Description

The present invention relates to a container, particularly for electronic equipment, of the type including a dish-like body and a flat cover.

It is particularly important to be able to remove the cover of such a container quickly. Moreover, in order to protect the electronic equipment therein, the container must be sealed perfectly against external agents.

In order to achieve these objects, the dish-like body of the container according to the invention has a plurality of catch projections on opposite side walls, and the cover has a plurality of resilient appendages on two opposed portions of its periphery for engaging the corresponding catch projections of the dish-like body in order to clamp the cover to the body.

An annular seal of elastomeric material is preferably interposed between the dish-like body and the cover.

By virtue of these characteristics, the cover can repeatedly be removed and replaced quickly by virtue of the resilient engagement between the catch projections of the dish-like body and the resilient appendages of the cover.

The catch projections of the dish-like body preferably have sloping portions for cooperating with the resilient appendages of the cover as the flat cover slides relative to the dish-like body so as to compress the annular seal resiliently.

The annular seal is therefore squashed uniformly, thus ensuring that the container is closed hermetically. Moreover, the cover is not damaged when it is removed and can therefore be reused.

Further advantages and characteristics of the container according to the invention will become clear from the detailed description which follows purely by way of non-limiting example, with reference to the appended drawings in which:

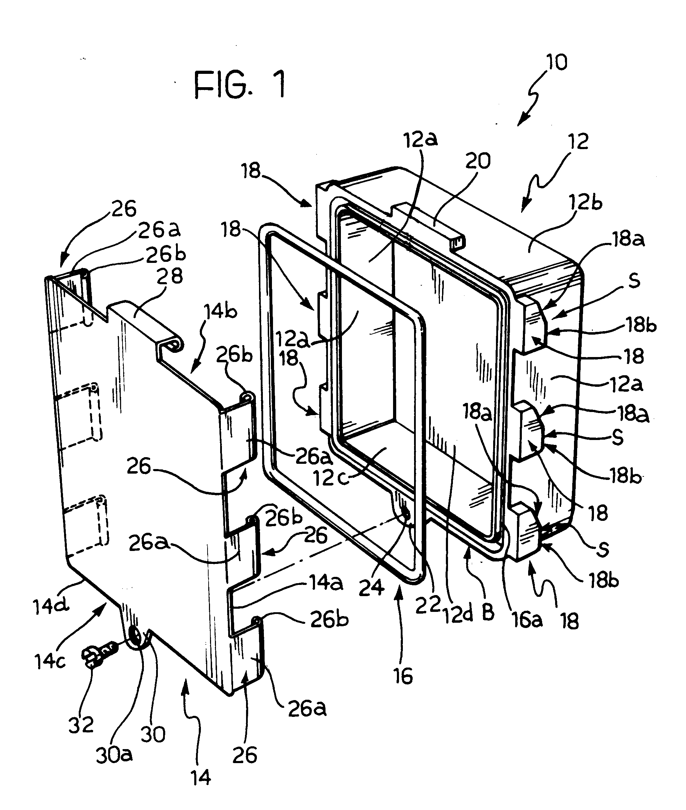

Figure 1 is an exploded perspective view of a container according to the invention,
Figures 2-4 are side views of the container showing the fitting of the cover, and
Figure 5 is a section taken on the line V-V of Figure 4.

With reference to the drawings, a metal container for electronic components, generally indicated 10, includes a quadrangular dish-like aluminium body 12, a flat sheet-metal cover 14 and an annular seal 16 of elastomeric material which is interposed between the body 12 and the cover 14 and fitted in an annular groove 16a in a flat edge B of the body 12.

The body 12 has two opposed, parallel flat walls 12a from which six shaped external catch projections 18 project outwardly in opposed pairs adjacent the edge B. Each catch projection 18 is integral with the dish-like body 12, is substantially parallelepipedal and, on its side which faces away from the edge B, defines a surface S including a sloping surface portion 18a and a flat portion 18b which is parallel to the plane in which the cover 14 lies on the edge B of the body 12. A third side wall 12b of the dish-like body 12 has an auxiliary catch projection 20 adjacent the edge B and a fourth wall 12c has a projection 22 with a threaded hole 24, the axis of which is substantially perpendicular to a base wall 12d of the dish-like body 12.

The flat cover 14 has two parallel sides 14a which correspond to the parallel sides 12a of the dish-like body 12 and have L-shaped resilient appendages 26, each defining a first portion 26a substantially perpendicular to the plane of the cover and a second portion 26b which has a substantially open, circular cross-section and is adapted to act as a resilient element, as will become clear from the following description. A third side 14b of the cover 14 has an auxiliary resilient appendage 28 substantially similar to the appendages 26 and a fourth side 14c of the cover 14 has an appendage 30 which is disposed in the plane of the cover and has a through-hole 30a.

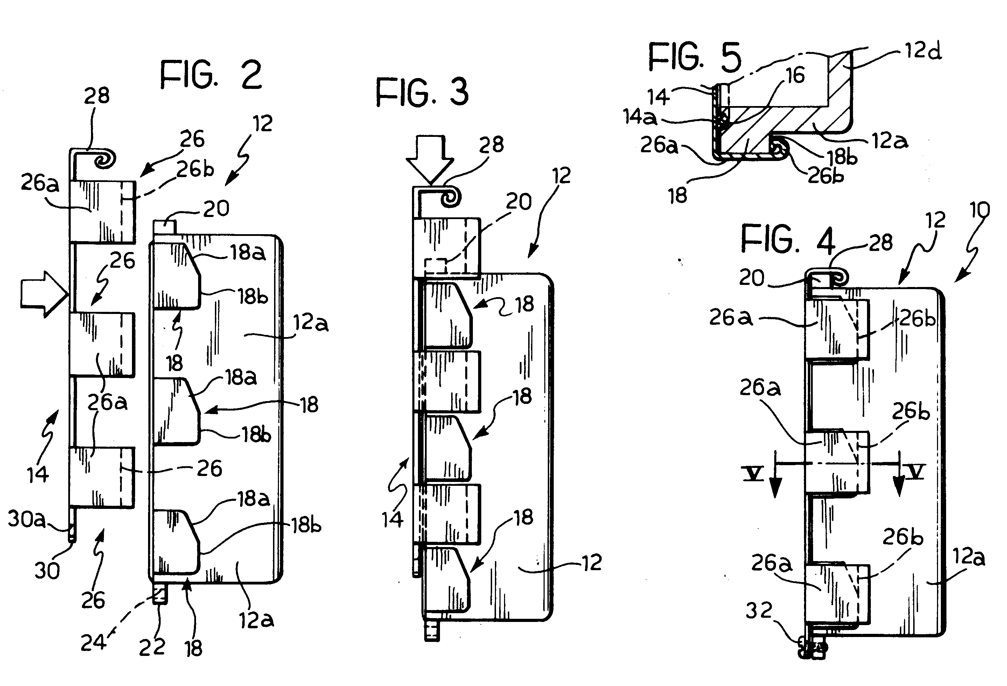

The appendages 26 which project from the plane of the cover 14, and the auxiliary appendage 28, are disposed on the cover 14 in positions corresponding to those of the catch projections 18 and of the auxiliary catch projection 20 of the dish-like body 12, respectively. The cover 14 can thus be fitted on the dish-like body 12 quickly according to the sequence shown in Figures 2, 3 and 4.

In a first step (Figure 2), the resilient appendages 26 are inserted in the spaces between the catch projections 18 so that the flat portion of the cover 14, indicated 14d in the drawings, can contact the annular seal 16 fitted in the groove 16a of the dish-like body 12. When this configuration (shown in Figure 3) has been achieved, it suffices to push the cover 14 in the direction indicated by the arrow so that the resilient portions 26b of the appendages 26 cooperate with the sloping portions 18a of the surfaces S of the catch projections 18. The relative sliding between the cover and the dish-like body thus squashes the seal 16 progressively until the six portions 26b of the appendages 26 abut the surface portions 18b of the catch projections 18 and the auxiliary appendage 28 abuts the corresponding auxiliary catch projection 20 (Figure 4).

In this operative configuration, the maximum squashing of the annular seal 16 and the best seal against external agents are achieved. In order to prevent the cover 14 from being opened accidentally, it may be fixed to the dish-like body 12 by a screw 32 inserted through the hole 30a in the appendage 30 of the cover 14 and screwed into the threaded hole 24 in the body 12.

In order to remove the cover 14 quickly, it suffices to remove the screw 32 and repeat the steps described in reverse.

## Claims

1. A container, particularly for electronic equipment, of the type including a dish-like body (12) and a flat cover (14), characterised in that the dish-like body (12) has a plurality of catch projections (18) on opposite side walls (12a), and in that the cover (14) has a plurality of resilient appendages (26) on two opposed portions (14a) of its periphery for engaging the corresponding catch projections (18) of the dish-like body (12) in order to clamp the cover (14) to the body (12).

2. A container according to Claim 1, characterised in that an annular seal (16) of elastomeric material is interposed between the dish-like body (12) and the cover (14).

3. A container according to Claim 2, characterised in that the catch projections (18) of the dish-like body (12) have sloping portions (18a) for cooperating with the resilient appendages (26, 26b) of the cover (14) as the cover (14) slides relative to the dish-like body (12) in order to squash the annular seal (16) resiliently.

4. A container according to any one of the preceding claims, characterised in that the catch projections (18) are disposed on opposed parallel side walls (12a) of the dish-like body (12) and in that the body (12) has at least one auxiliary catch projection (20) on a third side wall (12b) perpendicular to the opposed walls (12a) for cooperating with an auxiliary resilient appendage (28) on the cover (14).

5. A container according to Claim 2, characterised in that each catch projection (18) of the dish-like body (12) is disposed in correspondence with an edge region (B) of the body (12) and has a surface (S) which faces away from the cover (14) and includes a flat portion (18a), which is inclined to the plane in which the cover (14) lies, and is connected to a flat portion (18b) parallel to that plane.

6. A container according to any one of the preceding claims, characterised in that each resilient appendage (26) of the cover (14) is substantially L-shaped and defines a first portion (26a) perpendicular to the cover (14) and a second, bent, resilient portion (26b).

7. A container according to any one of the preceding claims, characterised in that screw-and-thread clamping means (32, 30, 30a, 24, 22) are interposed between the cover (14) and the dish-like body (12).

## Patentansprüche

1. Behälter, insbesondere für Elektronikausrüstung, in Art eines schalenähnlichen Körpers (12) und einer flachen Abdeckung (14),
**dadurch gekennzeichnet**,
daß der schalenähnliche Körper (12) eine Vielzahl von Verschlußvorsprüngen (18) an gegenüberliegenden Seitenwänden (12a) aufweist und daß die Abdeckung (14) eine Vielzahl elastischer Ansätze (26) an zwei gegenüberliegenden Abschnitten (14a) ihres Umfangs zum Eingreifen in den entsprechenden Verschlußvorsprüngen (18) des schalenähnlichen Körpers (12) aufweist, um die Abdeckung (14) an dem Körper (12) festzuklemmen.

2. Behälter nach Anspruch 1,
**dadurch gekennzeichnet**,
daß eine umlaufende Dichtung (16) aus Elastomer-Material zwischen dem schalenähnlichen Körper (12) und der Abdeckung (14) eingefügt ist.

3. Behälter nach Anspruch 2,
**dadurch gekennzeichnet**,
daß die Verschlußvorsprünge (18) des schalenähnlichen Körpers (12) geneigte Abschnitte (18a) zum Zusammenwirken mit den elastischen Ansätzen (26, 26b) der Abdeckung (14) aufweisen, wenn die Abdeckung (14) relativ zu dem schalenähnlichen Körper (12) gleitet, um die umlaufende Dichtung (16) elastisch zusammen zu drücken.

4. Behälter nach irgendeinem der vorhergehenden Ansprüche,
**dadurch gekennzeichnet**,
daß die Verschlußvorsprünge (18) an gegenüberliegenden, parallelen Seitenwanden (12a) des schalenähnlichen Körpers (12) angeordnet sind und daß der Körper (12) zumindest einen Hilfsverschlußvorsprung (20) an einer dritten, in bezug auf die gegenüberliegenden Seitenwänden (12a) senkrechten Seitenwand (12b) zum Zusammenwirken mit einem elastischen Hilfsansatz (28) an der Abdeckung (14) aufweist.

5. Behälter nach Anspruch 2,
**dadurch gekennzeichnet**,
daß jeder Verschlußvorsprung (18) des schalenähnlichen Körpers (12) korrespondierend zu einem Eckbereich (B) des Körpers (12) angeordnet ist und eine Fläche (S) aufweist, die weg von der Abdeckung (14) gerichtet ist und einen flachen Abschnitt (18a) umfasst, der relativ zu der Ebene geneigt ist, in der die Abdeckung (14) liegt, und mit einem flachen Abschnitt (18b), der parallel zu dieser Ebene verläuft, verbunden ist.

6. Behälter nach irgendeinem der vorhergehenden Ansprüche,
**dadurch gekennzeichnet**,
daß jeder elastische Vorsprung (26) der Abdeckung (14) im wesentlichen L-förmig ist und einen zu der Abdeckung (14) senkrechten ersten Abschnitt (26a) und einen zweiten gebogenen, elastischen Abschnitt (26b) aufweist.

7. Behälter nach irgendeinem der vorhergehenden Ansprüche,
**dadurch gekennzeichnet**,
daß Schraub- und Gewinde-Klemmelemente (32, 30, 30a, 24, 22) zwischen der Abdeckung (14) und dem schalenähnlichen Körper (12) eingefügt sind.

## Revendications

1. Boîtier , en particulier pour de l'équipement électronique, du type comprenant un corps en forme de cuvette (12) et un couvercle plat (14), caractérisé en ce que le corps en forme de cuvette (12) est pourvu d'une pluralité de crochets en saillie (18) sur des parois latérales opposées (12a), et en ce que le couvercle (14) est pourvu d'une pluralité d'attaches élastiques (26) sur deux parties opposées (14a) de sa périphérie destinées à s'engager dans les crochets en saillie (18) correspondants du corps en forme de cuvette (12), afin d'assembler le couvercle (14) sur le corps (12).

2. Boîtier selon la revendication 1, caractérisé en ce qu'un joint annulaire (16) en matériau de type élastomère est interposé entre le corps en forme de cuvette (12) et le couvercle (14).

3. Boîtier selon la revendication 2, caractérisé en ce que les crochets en saillie (18) du corps en forme de cuvette (12) sont pourvus de parties inclinées (18a) pour coopérer avec les attaches élastiques (26, 26b) du couvercle (14) lorsque le couvercle (14) glisse par rapport au corps en forme de cuvette (12) afin d'écraser le joint annulaire (16) de façon élastique.

4. Boîtier selon l'une quelconque des revendications précédentes, caractérisé en ce que les crochets en saillie (18) sont disposés sur des parois latérales parallèles opposées (12a) du corps en forme de cuvette (12) et en ce que le corps (12) est pourvu d'au moins un crochet auxiliaire en saillie (20) sur une troisième paroi latérale (12b) perpendiculaire aux parois opposées (12a) afin de coopérer avec une attache élastique auxiliaire (28) située sur le couvercle (14).

5. Boîtier selon la revendication 2, caractérisé en ce que chaque crochet en saillie (18) du corps en forme de cuvette (12) est disposé en correspondance avec une zone de bord (B) du corps (12) et est pourvu d'une face (S) qui est à l'opposé par rapport au couvercle (14), et comprend une partie plane (18a), qui est inclinée par rapport au plan d'appui du couvercle (14), et est reliée à une partie plane (18b) parallèle à ce plan.

6. Boîtier selon l'une quelconque des revendications précédentes, caractérisé en ce que les attaches élastiques (26) du couvercle (14) sont pratiquement en forme de L et comprennent une première partie (26a) perpendiculaire au couvercle (14) et une seconde partie élastique courbe (26b).

7. Boîtier selon l'une quelconque des revendications précédentes, caractérisé en ce que des moyens de fixation par vis et taraudage (32, 30, 30a, 24, 22) sont interposés entre le couvercle (14) et le corps en forme de cuvette (12).
